# EUROPEAN PATENT APPLICATION

(11) **EP 2 693 489 A1**
(43) Date of publication of application: **05.02.2014**
(21) Application number: 12762953.3
(22) Date of filing: 26.03.2012
(51) Int. Cl.: H01L 31/042

(54) **SOLAR CELL MODULE AND METHOD FOR PRODUCING SOLAR CELL MODULE**

(30) Priority: 29.03.2011 JP 2011072440
(71) Applicant: Dexerials Corporation, Tokyo 141-0032 (JP)
(72) Inventor: SUGA, Yasuhiro, Tokyo 141-0032 (JP)
(74) Representative: Müller - Hoffmann & Partner
(86) International application number: PCT/JP2012/057793
(87) International publication number: WO 2012/133340

(57) **Abstract**

In order to improve adhesion strength near the ends of tab wire, and improve power collection efficiency, a solar cell module is provided with a plurality of solar cells (2), and tab wire (3) that connects the plurality of solar cells (2) to one another by being adhered, via a conductive adhesive (17) containing spherical conductive particles (23), to electrodes (11), (13) formed respectively on the front surface of a solar cell (2) and on the rear surface of a neighboring solar cell (2), and a bending section (18) is formed by bending the lengthwise-direction end of the tab wire (3) toward the electrode (11), (13) side.

## Description

### Field of the Invention

This invention relates to a solar cell module in which a plurality of solar cells are connected with one after another with tab wires, and in particular concerns a solar cell module in which the tab wires to be connected to electrodes of the solar cell via a conductive adhesive containing conductive particles are improved as well as a method for producing such a solar cell module.

The present application asserts priority rights based on JP Patent Application 2011-72440 filed in Japan on March 29, 2011. The total contents of disclosure of the Patent Application of the senior filing date are to be incorporated by reference into the present Application.

### Background of the Invention

For example, in a crystal silicon-based solar cell module, a plurality of adjacent solar cells are connected with tab wires serving as interconnectors. Each tab wire has its one end connected to a front surface electrode of one solar cell, with the other end being connected to a rear surface electrode of an adjacent solar cell, so that the respective solar cells are connected in series with one after another. At this time, in the tab wires, one front surface on one end side is adhered to a front surface electrode of one solar cell, with the other surface on the other end side being adhered to a rear surface electrode of an adjacent solar cell.

More specifically, in the solar cell, bus bar electrodes are formed on a light-receiving surface by screen printing of a silver paste or the like, and an Ag electrode is formed on a rear-surface connection portion of the solar cell. Additionally, on an area other than the rear-surface connection portion of the solar cell, Al electrodes and Ag electrodes are formed.

The tab wire is formed by placing a solder coat layer on each of the two surfaces of a ribbon-shaped copper foil. More specifically, the tab wire is formed by processes in which a copper foil that has been subjected to a rolling process into a thickness in a range of 0.05 to 0.2 mm is slit, or a copper wire is subjected to a rolling process into a flat plate shape, so that a flat rectangular-shaped copper wire having a width of 1 to 3 mm is obtained, and by carrying a solder plating, a dip soldering or the like on the copper wire.

The connection between the solar cells and the tab wire is carried out through processes in which the tab wire is placed on each of the electrodes of solar cells and heated and pressed by a heating bonder so that the solder formed on the surface of the tab wire is melted and cooled (Patent Document 1).

However, in the case of soldering, since a connecting process at a high temperature of about 260°C is carried out, the connection reliability between the tab wire and the front surface electrode as well as the rear surface electrode of the solar cell might deteriorate due to warping in the solar cell, an inner stress caused in the connection portion between the tab wire and the front surface electrode as well as the rear surface electrode, residues of flux, and the like.

Therefore, conventionally, the connection between the front surface electrode as well as the rear surface electrode of solar cells and the tab wire is carried out by using a conductive adhesion film capable of being connected by a thermal press-bonding process at a comparatively low temperature (Patent Document 2). As such a conductive adhesion film, a material which is prepared by dispersing spherical or scale-shaped conductive particles having an average particle size in the order of several µms in a thermosetting binder resin composition is formed into a film and utilized.

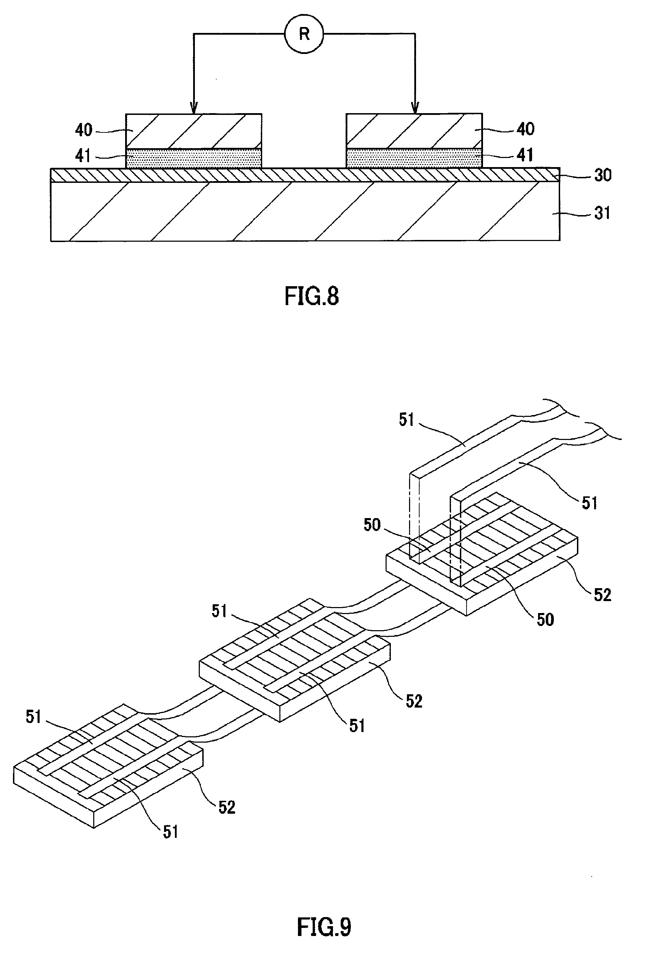

As shown in Fig. 9, after a conductive adhesion film 50 has been interpolated between the front surface electrode as well as the rear surface electrode and a tab wire 51, by heating and pressing this by a heating bonder from the tab wire 51, the binder resin exerts flowability to flow out between the electrodes and the tab wire 51, with the conductive particles being sandwiched between the electrodes and the tab wire 51 to provide conduction between these; thus, the binder resin is thermally cured in this state. Thus, strings in which a plurality of solar cells 52 are series-connected to one after another by the tab wires 51 are formed.

The plural solar cells 52 whose front surface electrode and rear surface electrode are connected to the tab wires 51 by using the conductive adhesion film 50 are sealed between a surface protective material with translucency such as glass, a translucent plastic material or the like and a back surface protective material made of a film such as PET (Poly Ethylene Terephthalate) or the like, by using a sealing material having translucency, such as ethylene vinyl acetate resin (EVA).

### Prior-Art Documents

### Patent Document

PTL 1: Japanese Patent Application Laid-Open No. 2004-356349
PTL 2: Japanese Patent Application Laid-Open No. 2008-135654

### Summary of the Invention

In this case, in the connection method for the tab wire 51 by the use of the conductive adhesion film 50, desired adhesive property and conductivity can be obtained by uniformly heating and pressing the tab wire 51 over the entire length thereof. On the other hand, the uniform heating and pressing processes of the tab wire 51 tend to be adversely affected by the shape and irregularities of the electrode, and in particular, in the vicinity of the ends of the tab wire 51, the applied heat and pressure tend to become unstable.

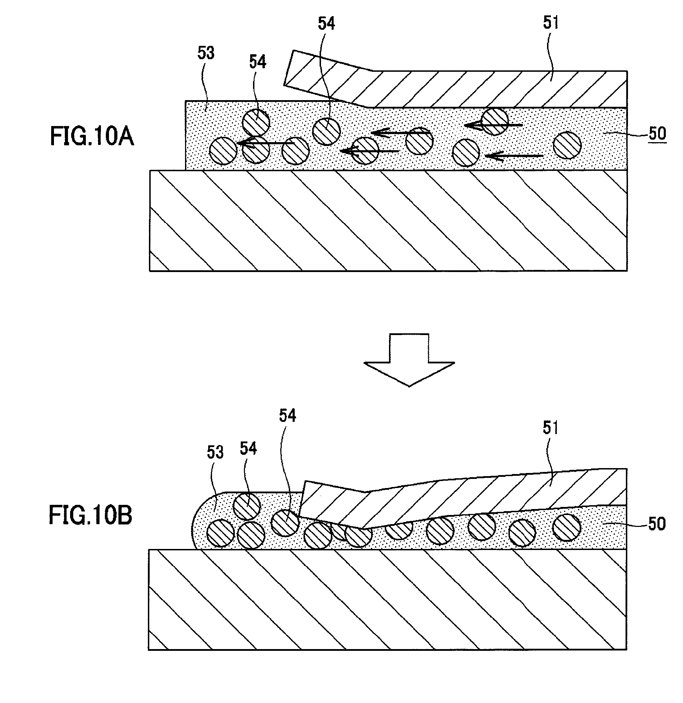

For this reason, as shown in Fig. 10(a), in the vicinity of the ends of the tab wire 51, when heated and bonded by the heating bonder, the binder resin 53 and the conductive particles 54 tend to flow externally as shown in Fig. 10(b). Consequently, the adhesion strength of the tab wire 51 to the electrode becomes weaker in the vicinity of the ends, and the capturing rate of the conductive particles 54 is lowered, with the result that the connection reliability and power collection efficiency might deteriorate.

Therefore, the object of the present invention is to provide a solar cell module that can improve the adhesion strength in the vicinity of the ends of the tab wire and also improve the power collection efficiency, and a method of producing such a solar cell module.

In order to solve the above-mentioned problems, a solar cell module in accordance with the present invention is provided with: a plurality of solar cells and a tab wire that connects the plurality of solar cells to one another by being adhered, via a conductive adhesive containing spherical conductive particles, to electrodes formed respectively on the front surface of a solar cell and on the rear surface of a neighboring solar cell so as to connect the plurality of solar cells to one after another, and in this structure the tab wire has a bending section formed thereon in which an end portion in the longitudinal direction is bent onto the electrode side.

Moreover, in a method of producing a solar cell module in accordance with the present invention is provided with the steps of: disposing one end of a tab wire on a front surface electrode of a solar cell via a conductive adhesive containing spherical conductive particles, as well as disposing the other end of the tab wire on a rear surface electrode of a solar cell adjacent to the solar cell via a conductive adhesive containing conductive particles; and heating and pressing the tab wire onto the front surface electrode and the rear surface electrode so that the tab wire is adhered onto the front surface electrode and the rear surface electrode via the conductive adhesive, and in this method, the tab wire has a bending section formed thereon in which an end portion in the longitudinal direction is bent onto the electrode side.

### Effects of Invention

In accordance with the present invention, the tab wire is designed such that its bending section presses down a conductive adhesive having flowability so as to prevent the binder resin of the conductive adhesive from flowing out with an unnecessarily high amount between the tab wire and the electrode and also to capture conductive particles that are dispersed inside the binder resin. Therefore, in accordance with the present invention, it becomes possible to prevent degradation of the adhesion strength to the electrode near the ends of the tab wire and also to prevent degradation of the capturing rate of the conductive particles, thereby making it possible to maintain or improve the connection reliability and power collection efficiency.

### Brief Description of Drawings

Figure 1 is an exploded perspective view showing a solar cell module.
Figure 2 is a cross-sectional view showing strings of a solar cell.
Figure 3 is a plan view showing a rear surface electrode and a connection portion of the solar cell.
Figure 4 is a cross-sectional view showing a bending section of a tab wire.
Figure 5 is a cross-sectional view showing a conductive adhesion film.
Figure 6 is a view showing the conductive adhesion film wound up into a reel shape.
Figures 7A and 7B are cross-sectional views showing a connection process of tab wires.
Figure 8 is a cross-sectional view showing an example and a comparative example.
Figure 9 is a perspective view showing a conventional solar cell module.
Figure 10 is a cross-sectional view showing a connection process of tab wires in a conventional solar cell module.

### Detailed Description of the Invention

Referring to Figures, the following description will discuss a solar cell module to which the present invention is applied and a method of manufacturing the solar cell module in detail. Additionally, the present invention is not intended to be limited only by the following embodiments, and it is needless to say that various modifications may be made within the scope not departing from the gist of the invention.

### [Solar Cell Module]

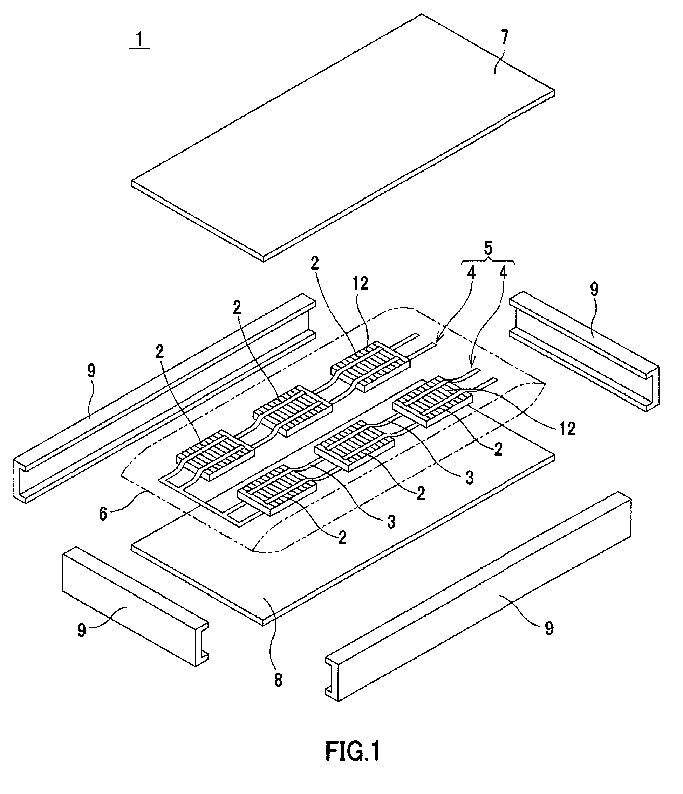

As shown in Figs. 1 to 3, a solar cell module 1 to which the present invention is applied is provided with strings 4 each having a plurality of solar cells 2 that are series-connected by tab wires 3 serving as interconnectors, and a matrix 5 in which a plurality of the strings 4 are arranged. Moreover, the solar cell module 1 is formed by processes in which the matrix 5 is sandwiched by sheets 6 made of a sealing adhesive, and laminated as one package together with a surface cover 7 formed on a light-receiving surface side and a back sheet 8 formed on a rear surface side, and lastly, a metal frame 9 made of aluminum or the like is attached on the periphery thereof.

As the sealing adhesive, for example, a translucent sealing material, such as an ethylene vinyl acetate resin (EVA) or the like, is used. As the surface cover 7, for example, a translucent material, such as glass or a translucent plastic material, is used. As the back sheet 8, a laminate member or the like in which glass or an aluminum foil is sandwiched by resin films is used.

Each solar cell 2 of the solar cell module is provided with a photoelectric conversion element 10. As the photoelectric conversion element 10, various kinds of photoelectric conversion elements 10, such as a crystal silicon-based solar cell using a single crystal type silicon photoelectric conversion element or a polycrystal type photoelectric conversion element, a thin-film silicon-based solar cell made of amorphous silicon, a multi-junction type thin-film silicon-based solar cell in which a cell made of amorphous silicon and a cell made of a microcrystal silicon or amorphous silicon germanium are laminated, a so-called compound thin-film-based solar cell, an organic solar cell, a quantum dot type solar cell, and the like, may be used.

Moreover, on a light-receiving surface of the photoelectric conversion element 10, finger electrodes 12 that collect electricity generated the inside thereof, and busbar electrodes 11 that collect electricity of the finger electrodes 12 are installed. The busbar electrodes 11 and the finger electrodes 12 are formed by processes in which, for example, an Ag paste is applied onto the surface forming a light-receiving surface of the solar cell 2 by a screen printing method or the like, and this is then baked. Moreover, the finger electrodes 12 have a structure in which a plurality of lines, each having a width of, for example, about 50 to 200µm, are formed virtually in parallel with one another with every predetermined intervals, for example, every other 2 mm, over the entire surface of the light-receiving surface. The busbar electrodes 11 are formed so as to be virtually orthogonal to the finger electrodes 12, and a plurality of them are formed in accordance with the area of the solar cell 2.

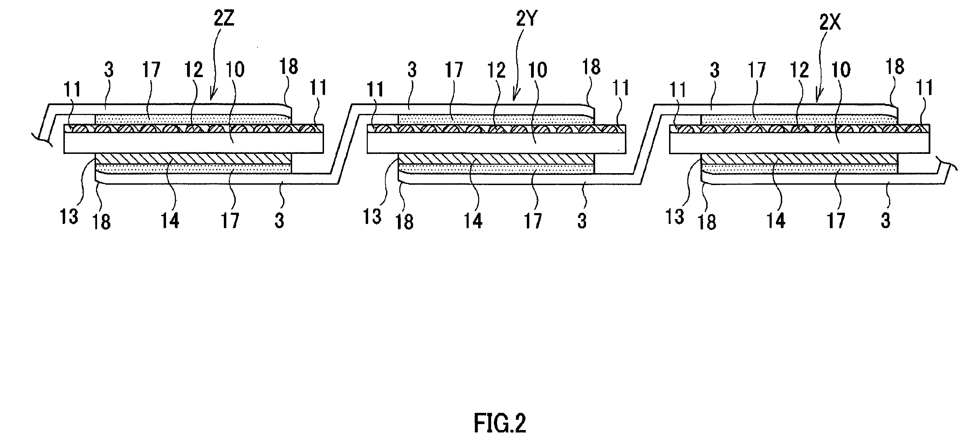

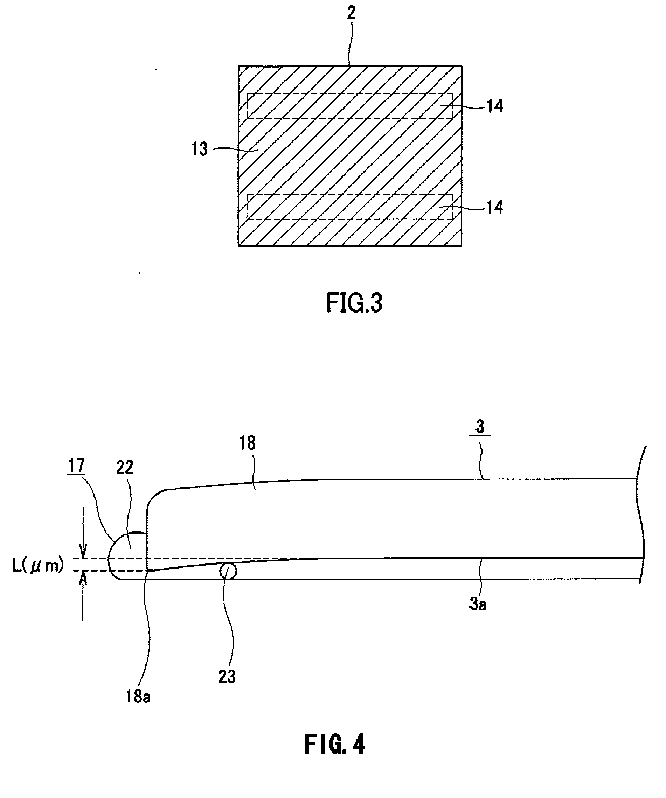

Moreover, the photoelectric conversion element 10 is provided with a rear surface electrode 13 made of aluminum or silver, which is formed on a rear-surface side opposite to the light-receiving surface. As shown in Figs. 2 and 3, the rear surface electrode 13 is formed as an electrode made of, for example, aluminum or silver, which is formed on the rear surface of the solar cell 2 by using a screen printing method, a sputtering method, or the like. The rear surface electrode 13 is provided with a tab wire connection unit 14 to which a tab wire 3 is connected via a conductive adhesion film 17, which will be described later.

Moreover, the solar cell 2 has such a structure that each of the busbar electrodes 11 formed on the surface is electrically connected to the rear surface electrodes 13 of an adjacent solar cell 2 by the tab wire 3 so that strings 4 that are series-connected to one another are formed. The tab wire 3, the busbar electrodes 11 and the rear surface electrode 13 are connected to one another by the conductive adhesion film 17, which will be described later.

### [Tab Wire]

As shown in Fig. 2, the tab wire 3 is a conductive base member having an elongated shape that electrically connects adjacent solar cells 2X, 2Y and 2Z with one after another. Upon producing the tab wire 3, for example, a copper foil or an aluminum foil that has been subjected to a rolling process into a thickness of 50 to 300µm is slit, or a thin metal wire of copper or aluminum is subjected to a rolling process into a flat plate shape so that a flat rectangular-shaped copper wire having a width of 1 to 3 mm that is virtually the same width as that of the conductive adhesion film 17 is obtained. Then, by carrying out a gold plating, silver plating, tin plating, or solder plating process on the flat rectangular-shaped copper wire, if necessary, the tab wire 3 is formed.

### [Bending Section]

Moreover, as shown in Fig. 4, the tab wire 3 is provided with bending sections 18 that correspond to the end portion in the longitudinal direction thereof, which are bent toward the respective electrode 11 and 13 sides, when placed on the respective electrodes 11 and 13 of the solar cell 2. Each bending section 18 is designed such that, when the tab wire 3 is heated and pressed onto the busbar electrode 11 or the rear-surface electrode 13 through the conductive adhesion film 17 by using a heating bonder or the like, it prevents a binder resin 22 and conductive particles 23 at the ends of the tab wire 3 from flowing out between the tab wire 3 and the electrodes 11, 13, thereby making it possible to improve the adhesion strength and electrical connection reliability.

In the tab wire 3, each bending section 18 presses down the binder resin 22 having flowability so as to prevent the binder resin 22 from flowing out between the tab wire 3 and each of the electrodes 11 and 13 with an unnecessarily high amount, and also to capture conductive particles 23 dispersed inside the binder resin 22. Therefore, the solar cell module 1 is allowed to prevent degradation of the adhesion strength to the electrodes 11 and 13 near the ends of the tab wire 3, and also to prevent degradation of the capturing rate of the conductive particles 23 in the ends of the tab wire 3, thereby making it possible to maintain or improve the connection reliability and power collection efficiency.

Moreover, as shown in Fig. 4, the bending section 18 is designed such that a bending distance (L) from one main surface 3a of the tab wire 3 at which it is made in contact with the conductive adhesion film 17 to the tip end 18a of the bending section 18 and an average particle diameter (R) of conductive particles 23 contained in the conductive adhesion film 17 satisfy L ≤ R (L ≠ 0) as well as R - L ≤ 30µm.

When the bending distance (L) of the bending section 18 becomes longer than the average particle diameter (R) of the conductive particles 23, the outflow of the binder resin of the conductive adhesion film 17 is blocked and the conductive particles 23 might fail to be sandwiched by a gap to the electrode 11 and 13 at the end of the tab wire 3, with the result that the conductivity might be further impaired.

Moreover, when a difference between the average particle diameter (R) of the conductive particles 23 and the bending distance (L) of the bending section 18 becomes greater than 30µm, it becomes impossible to prevent the outflow of the binder resin and the conductive particles 23, with the result that degradation of the adhesion strength and degradation of the power collection efficiency due to the reduction of the capturing rate of the conductive particles 23 tend to occur.

Moreover, the difference between the average particle diameter (R) of the conductive particles 23 and the bending distance (L) of the bending section 18 is applicable when it is in a range from 30µm or less, and the difference is preferably set to 0 to 20µm. By setting the bending section 18 to satisfy R - L ≤ 0 to 20µm (0 ≤ R - L ≤ 20µm), it becomes possible to prevent the outflow of the binder resin, and to improve the capturing rate of the conductive particles 23 so that the adhesion strength between the tab wire 3 and the electrode 11 and 13 and the power collection efficiency can be effectively improved.

Additionally, the bending distance (L) of the bending section 18 can be adjusted by controlling a pressure and a space between the upper blade and the lower blade of a cutter at the time when the flat rectangular copper wire is cut by using a press cutter. Moreover, the bending distance (L) of the bending section 18 is applicable when it is in a range of 10 to 50µm, and the distance is preferably applied within a range of 10 to 30µm.

### [Adhesive Film]

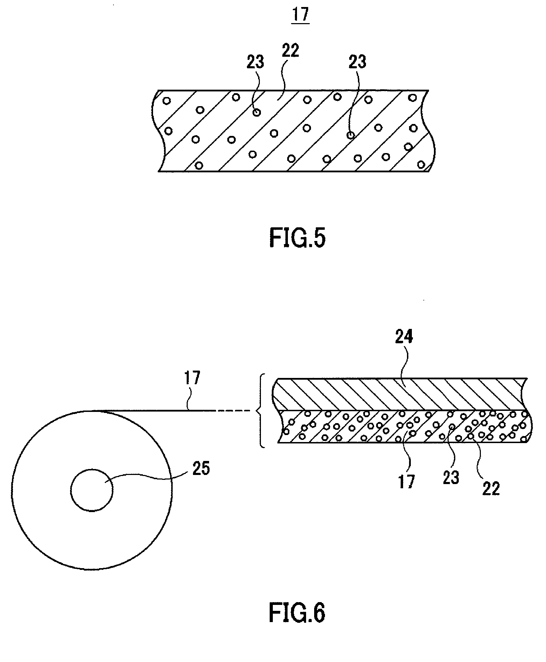

As shown in Fig. 5, the conductive adhesion film 17 is a thermosetting binder resin layer in which the spherical conductive particles 23 are contained in the binder resin 22 at high density. Moreover, from the viewpoint of indenting property, the conductive adhesion film 17 is preferably set to have the lowest melt viscosity of the binder resin 22 in a range from 100 to 100000 Pa•s. When the lowest melt viscosity of the conductive adhesion film 17 is too low, the resin tends to flow from a low press-bonding process to a main curing process to cause any connection failure or any protrusion onto the cell light receiving surface, resulting in a reduction in light receiving rate. Moreover, when the lowest melt viscosity is too high, a problem tends to occur upon pasting the film, resulting in any adverse effect to connection reliability. Additionally, the lowest melt viscosity can be measured by loading a predetermined amount of a sample to a rotary viscometer and measuring the viscosity while raising the temperature at a predetermined rate.

Although not particularly limited, as the spherical conductive particles 23 used for the conductive adhesion film 17, examples thereof include: metal particles such as nickel, gold, silver and copper, resin particles that are subjected to gold plating or the like, and those resin particles that are subjected to gold plating, with their outermost layer being coated with an insulating material. In the present embodiment, the nickel particles are desirably used. Additionally, the spherical shape in the present invention is not limited to a so-called globular shape, but includes all sorts of shapes which can be taken by metal particles and resin particles and from which the particle diameter is assumed, such as polyhedrons or the like composed of flat faces and curved faces, in addition to globular shapes with virtually round shapes and elliptical shapes in their cross sections.

Moreover, the conductive adhesion film 17 preferably has a viscosity in a range from 10 to 10000 kPa•s, and more preferably, from 10 to 5000 kPa•s, at about normal temperature. By setting the viscosity of the conductive adhesion film 17 in the range from 10 to 10000 kPa•s, it becomes possible to prevent blocking due to so-called protrusion at the time when the conductive adhesion film 17 is wound into a reel shape as a tape, and also to maintain a predetermined tacking strength.

Although not particularly limited as long as the above-mentioned characteristics are not impaired, the composition of the binder resin 22 of the conductive adhesion film 17 preferably includes a film-forming resin, a liquid-state epoxy resin, a potential curing agent and a silane coupling agent.

The film-forming resin corresponds to a high-molecular-weight resin having an average molecular weight of 10000 or more, and from the viewpoint of a film forming characteristic, preferably, the average molecular weight thereof is set to about 10000 to 80000. As the film-forming resin, various resins, such as an epoxy resin, a modified epoxy resin, a urethane resin, a phenoxy resin and the like, may be used, and among these, from the viewpoint of film-forming state, connection reliability, etc., the phenoxy resin is preferably used.

As the liquid-state epoxy resin, not particularly limited as long as it has flowability at normal temperature, any commercially-available epoxy resin may be used. Specific examples of these epoxy resins include: naphthalene-type epoxy resins, biphenyl-type epoxy resins, phenol novolak-type epoxy resins, bisphenol-type epoxy resins, stilbene-type epoxy resins, triphenol methane-type epoxy resins, phenol aralkyl-type epoxy resins, naphthol-type epoxy resins, dicyclopentadiene-type epoxy resins and triphenyl methane-type epoxy resins. One of these may be used alone, or two kinds or more of these may be used in combination. Moreover, another organic resin, such as an acrylic resin, may be used in combination on demand.

As the potential curing agent, various curing agents, such as hot setting-type, UV-setting-type or the like curing agent, may be used. The potential curing agent is not allowed to react normally, but is activated with a certain trigger, and starts a reaction. As the trigger, heat, light, pressure or the like is used, and by making selection among these depending on the application, any of these may be used. Among these, in the present invention, the potential curing agent of a hot setting-type is preferably used, and the curing agent is subjected to a main curing process by being heated and pressed onto the busbar electrode 11 and the rear-surface electrode 13. In the case when a liquid-state epoxy resin is used, a potential curing agent made of imidazoles, amines, sulfonium salts, onium salts, or the like, may be used.

As the silane coupling agent, epoxy-based, amino-based, mercapto-sulfide-based, or ureide-based agents may be used. Among these, in the present embodiment, an epoxy-based silane coupling agent is preferably used. Thus, it is possible to improve an adhesive property on an interface between the organic material and the inorganic material.

Moreover, as another additive composition, an inorganic filler is preferably contained. When the inorganic filler is contained therein, the flowability of a resin layer upon press-bonding can be adjusted so that the particle capturing rate can be improved. As the inorganic filler, such as silica, talc, titanium oxide, calcium carbonate, magnesium oxide or the like, may be used, and the kind of the inorganic filler is not particularly limited.

Fig. 6 is a schematic view that shows one example of a product mode of the conductive adhesion film 17. The conductive adhesion film 17 is provided with a peeling base member 24 with a binder resin 22 laminated thereon, and these are molded into a tape shape. This tape-shaped conductive adhesion film 17 is wound around and stacked on a reel 25, with the peeling base member 24 being located on the peripheral side. As the peeling base member 24, not particularly limited, PET (Poly Ethylene Terephthalate), OPP (Oriented Polypropylene), PMP (Poly-4-methylpentene-1), PTFE (Polytetrafluoroethylene) and the like may be used. Moreover, the conductive adhesion film 17 may have a structure in which a transparent cover film is formed on the binder resin 22.

At this time, as the cover film to be pasted onto the binder resin 22, the aforementioned tab wire 3 may be used. The conductive adhesion film 17 is stacked on one main surface 3 a in which the binder resin 22 is aligned along the bending direction of the bending section 18 of the tab wire 3. In this manner, by preliminarily stacking the tab wire 3 and the conductive adhesion film 17 as one integral laminate, the peeling base member 24 can be separated at the time of an actual application, and by pasting the binder resin 22 of the conductive adhesion film 17 onto tab wire connection portions 14 of the busbar electrodes 11 and the rear surface electrode 13 so that the tab wire 3 and the respective electrodes 11 and 13 can be connected to one another.

In the above description, the conductive adhesion film having a film shape has been explained; however, the film in a paste state may be used without causing any problems. In the present application, the film-shaped conductive adhesion film 17 or a conductive adhesion paste in a paste state containing conductive particles is defined as "conductive adhesive".

Additionally, not particularly limited to the reel shape, the conductive adhesion film 17 may be formed into a strip shape in accordance with the shapes of the tab wire connection portions 14 of the busbar electrodes 11 and the rear surface electrode 13.

In the case when the conductive adhesion film 17 is provided as a reel product as shown in Fig. 6, by setting the viscosity of the conductive adhesion film 17 in a range from 10 to 10000 kPa•s, it is possible to prevent the conductive adhesion film 17 from being deformed, and consequently to maintain predetermined dimensions thereof. Moreover, even in the case when the conductive adhesion film 17 has a strip shape and two or more sheets thereof are stacked, it is possible to prevent the deformation, and consequently to maintain predetermined dimensions thereof in the same manner.

The conductive adhesion film 17 is produced by dissolving conductive particles 23, a film-forming resin, a liquid-state epoxy resin, a potential curing agent and a silane coupling agent in a solvent. As the solvent, toluene, ethyl acetate, or the like, or a mixed solvent of these, may be used. The resin forming solution obtained by the dissolving process is applied onto a peeling sheet, and the solvent is volatilized so that the conductive adhesion film 17 is obtained.

Moreover, the conductive adhesion film 17 is cut into pieces having predetermined lengths for two surface electrodes and two rear-surface electrodes, and these pieces are temporarily pasted at predetermined positions on the surface and rear surface of a solar cell 2. At this time, the pieces of the conductive adhesion film 17 are temporarily pasted onto a plurality of the tab wire connection portions 14 of the respective busbar electrodes 11 and the rear-surface electrode 13 that are formed virtually in parallel with one another on the surface of the solar cell 2. Additionally, in the case when the conductive adhesion paste is used as the conductive adhesive, the conductive adhesion paste is applied onto the tab connection portions 14 of the busbar electrodes 11 and the rear-surface electrode 13.

Next, one of the main surfaces 3a of the tab wire 3 cut into a predetermined length in the same manner is superposed and placed on the conductive adhesion film 17. Thereafter, the conductive adhesion film 17 is heated and pressed from above the tab wire 3 by a heating bonder with predetermined temperature and pressure so that the binder resin 22 is flow out between each of the electrodes 11 , 13 and the tab wire 3, with the conductive particles 23 being sandwiched between the tab wire 3 and each of the electrodes 11 and 13, and in this state, the binder resin 22 is cured. Thus, in the conductive adhesion film 17, the tab wire 3 is adhered to the respective electrodes, with the conductive particles 23 being made in contact with the busbar electrodes 11 and the rear-surface electrode 13 so as to be conductively connected thereto.

### [Effects of Present Invention]

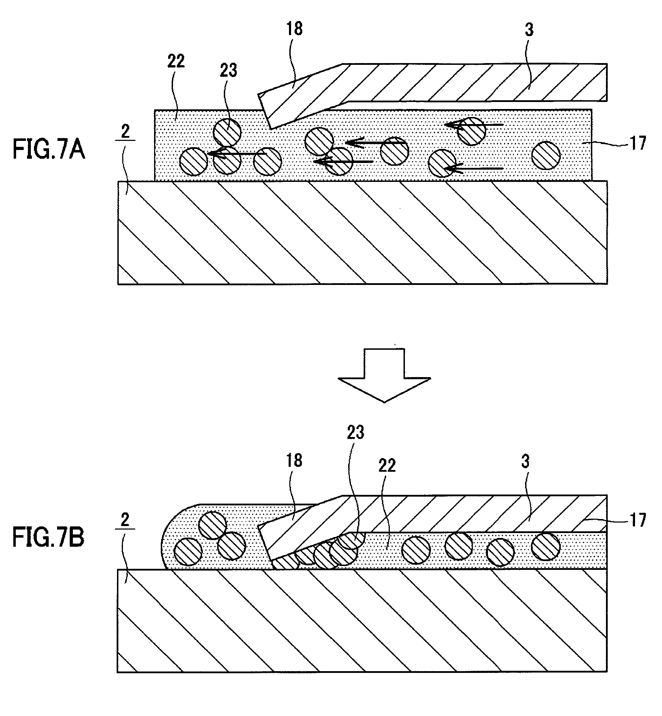

At this time, in the solar cell module 1, the bending section 18 is formed on the end of the tab wire 3 placed on the busbar electrode 11, with the conductive adhesion film 17 interposed therebetween. For this reason, as shown in Fig. 7A, when the tab wire 3 is heated and pressed by a heating bonder, the corresponding bending section 18 is allowed to invade into the binder resin 22 of the conductive adhesion film 17 that exerts flowability, as shown in Fig. 7B, so that the binder resin 22 is pressed down to the lower portion of the tab wire 3.

With this arrangement, in the solar cell module 1, the bending section 18 of the tab wire 3 prevents the binder resin 22 from flowing out with an unnecessarily high amount between the tab wire 3 and each of the electrodes 11 and 13, and also captures conductive particles 23 that are dispersed inside the binder resin 22. Therefore, the solar cell module 1 makes it possible to prevent degradation of the adhesion strength to the electrodes 11 and 13 near the ends of the tab wire 3 and also to prevent degradation of the capturing rate of the conductive particles 23 at the ends of the tab wire 3 so that it becomes possible to maintain or improve the connection reliability and power collection efficiency.

Moreover, in the solar cell module 1, the bending section 18 of the tab wire 3 may be designed such that, as shown in Fig. 4, a bending distance (L) from one main surface 3a of the tab wire 3 at which it is made in contact with the conductive adhesion film 17 to the tip end thereof and an average particle diameter (R) of conductive particles 23 contained in the conductive adhesion film 17 satisfy L ≤ R (L ≠ 0) as well as R - L ≤ 30µm. With this arrangement, the tab wire 3 allows the bending section 18 to appropriately prevent the outflow of the binder resin 22 and also to positively capture the conductive particles 23.

Moreover, in the solar cell module 1, a difference between the average particle diameter (R) of the conductive particles 23 and the bending distance (L) of the bending section 18 may be set to 0 to 20µm. Thus, the tab wire 3 allows its bending section 18 to prevent the outflow of the binder resin 22 and also to improve the capturing rate of the conductive particles 23 so that it becomes possible to effectively maintain or improve the adhesion strength between the tab wire 3 and the electrodes 11, 13, the connection reliability and the power collection efficiency.

In this manner, the solar cells 2 are successively connected to one after another by the tab wires 3 so that the strings 4 and the matrix 5 are formed. In this case, the plural solar cells 2 forming the matrix 5 are sealed by using a sheet 6 of a sealing material having a translucent property, such as an ethylene vinyl acetate resin (EVA), between a surface cover 7 having a translucent property, such as a translucent plastic material, and a back sheet 8 made of glass, a PET (Poly Ethylene Terephthalate) film or the like. Lastly, a metal frame 9 made of aluminum or the like is attached to the peripheral portion thereof so that the solar cell module 1 is formed.

### [Busbarless]

In addition to the structure in which, as described above, the busbar electrodes 11 that are virtually orthogonal to the finger electrodes 12 are installed on the light-receiving surface side of the solar cell 2, with the conductive adhesive and the tab wires 3 being stacked on the busbar electrodes 11, the solar cell module 1 may have a so-called busbarless structure in which, without installing the busbar electrodes 11, the conductive adhesive and the tab wires 3 are stacked so as to be orthogonal to the finger electrodes 12.

### [Packaged Laminate]

Moreover, in addition to the above-mentioned processing method in which after the conductive adhesive and the tab wires 3 have been disposed on the respective electrodes 11 and 13 of the solar cells 2, the tab wires 3 are heated and pressed from above by a heating bonder, the solar cell module 1 may be processed by another processing method in which on the surface and the rear surface of each solar cell 2, a conductive adhesive, tab wires 3 and a translucent sealing material sheet, such as EVA or the like, for sealing the tab wires 3 and the solar cells 2 are successively stacked, and the tab wires 3 may be heated and pressed onto the respective electrodes 11 and 13, by carrying out a packaged laminate process by using a reduced-pressure laminator.

### Examples

Next, the following description will discuss examples of the present invention. As shown in Fig. 8, samples 40 of the tab wire in which the bending distance (L) of the bending section 18 is changed and samples 41 of the conductive adhesion film in which the average particle diameter (R) of the conductive particles 23 is changed are prepared. As the tab wire 3, a solder dipped copper wire containing Pb (copper thickness 150µm, solder thickness 30µm, and width 4 mm) was used. These samples 40 of the tab wire were heated and pressed two by two onto an Ag electrode 30 of a glass substrate 31 over the entire surface of which the Ag electrode 30 was formed so as to be bonded thereto, with each of the samples 41 of the conductive adhesion film being interposed therebetween. In each of the processes, the heating and pressing conditions were set to 180°C, 10 seconds and 2 MPa.

With respect to the composition of the samples 41 of the conductive adhesion film, the following components were mixed to prepare a resin composition.
Phenoxy resin (YP-50: made by Nippon Steel Chemical Co., Ltd.) ; 20 parts by mass Liquid-state epoxy resin (EP828: made by Mitsubishi Chemical Corporation) ; 50 parts by mass
Nickel particles (made by Vale Inko Japan Limited) ; 10 parts by mass Imidazole-based potential curing agent (HX3941HP: made by Asahi Kasei Corporation) ; 20 parts by mass
Toluene ; 100 parts by mass

Thereafter, this resin composition was applied onto a polyethylene terephthalate film subjected to a peeling process having a thickness of 50µm so as to have a thickness of 25µm, and subjected to heating and drying processes for 5 minutes in an oven at 80°C so as to be formed into a film so that a sample 41 of the conductive adhesion film was prepared.

Thereafter, with respect to each of the samples, the adhesion strength (N/cm) of the tab wire thus bonded, the particle capturing rate (%), the initial conduction resistivity (Ω) between two tab wires and the conduction resistivity (Ω) after a thermal impact test (80°C, 80%RH, 500 hr) were measured.

The adhesion strength (N/cm) was measured by carrying out a 90°-peeling test (JIS K6854-1) in which the tab wire was separated in 90° direction. Moreover, the particle capturing rate (%) was calculated based upon the number of particles corresponding to an area of the tab wire prior to the bonding process of the tab wire and the number of particles located between the tab wire after the bonding process of the tab wire and the Ag electrode 30. The resistance value was measured by a four-terminal method in which a current terminal and a voltage terminal were respectively connected to two tab wires.

In example 1, as the tab wire 3, a wire having a bending distance (L) of the bending section 18 of 10µm was used. Moreover, as the conductive adhesion film 17, a film in which nickel particles having an average particle size (R) of 10µm were contained in a binder resin 22 was used. In example 1, R - L = 0µm was obtained.

In example 2, as the tab wire 3, the same wire as that of example 1 was used. Moreover, as the conductive adhesion film 17, a film in which nickel particles having an average particle size (R) of 15µm were contained in a binder resin 22 was used. In example 2, R - L = 5µm was obtained.

In example 3, as the tab wire 3, the same wire as that of example 1 was used. Moreover, as the conductive adhesion film 17, a film in which nickel particles having an average particle size (R) of 30µm were contained in a binder resin 22 was used. In example 3, R - L = 20µm was obtained.

In example 4, as the tab wire 3, the same wire as that of example 1 was used. Moreover, as the conductive adhesion film 17, a film in which nickel particles having an average particle size (R) of 40µm were contained in a binder resin 22 was used. In example 4, R - L = 30µm was obtained.

In example 5, as the tab wire 3, a wire having a bending distance (L) of the bending section 18 of 20µm was used. Moreover, as the conductive adhesion film 17, the same film as that of example 3 was used. In example 5, R - L = 10µm was obtained.

In example 6, as the tab wire 3, a wire having a bending distance (L) of the bending section 18 of 30µm was used. Moreover, as the conductive adhesion film 17, the same film as that of example 3 was used. In example 6, R - L = 0µm was obtained.

In example 7, as the tab wire 3, the same wire as that of example 6 was used. Moreover, as the conductive adhesion film 17, the same film as that of example 4 was used. In example 7, R - L = 10µm was obtained.

In comparative example 1, as the tab wire, a wire having no bending section (L = 0) was used. Moreover, as the conductive adhesion film, a film in which nickel particles having an average particle size (R) of 6µm were contained in a binder resin 22 was used.

In comparative example 2, as the tab wire 3, the same wire as that of example 5 was used. Moreover, as the conductive adhesion film 17, the same film as that of comparative example 1 was used. In comparative example 2, R - L =-14µm was obtained.

In comparative example 3, as the tab wire, a wire having no bending section (L = 0) was used. Moreover, as the conductive adhesion film, a film in which nickel particles having an average particle size (R) of 15µm were contained in a binder resin 22 was used.

**[Table 1]**

| | | Example 1 | Example 2 | Example 3 | Example 4 | Example 5 | Example 6 | Example 7 | Comparative Example 1 | Comparative Example 2 | Comparative Example 3 |
|---|---|---|---|---|---|---|---|---|---|---|---|
| Bending length L of tab wire (µm) | | 10 | 10 | 10 | 10 | 20 | 30 | 30 | 0 | 20 | 0 |
| Average particle diameter R of conductive particles (µm) | | 10 | 15 | 30 | 40 | 30 | 30 | 40 | 6 | 6 | 15 |
| R-L (µm) | | 0 | 5 | 20 | 30 | 10 | 0 | 10 | / | -14 | / |
| Adhesion strength (N/cm) | | 4.5 | 4.0 | 4.0 | 4.0 | 5.0 | 5.5 | 5.5 | 1.5 | 5.0 | 1.5 |
| Particle capturing rate (%) | | 60 | 70 | 80 | 60 | 85 | 80 | 75 | 30 | 35 | 40 |
| Initial conduction (Ω) | Maximum | 9 | 8 | 8 | 8 | 6 | 6 | 7 | 15 | 8 | 10 |
| | Average | 6 | 6 | 6 | 6 | 5 | 5 | 6 | 8 | 6 | 7 |
| Conduction after thermal impact test (Ω) | Maximum | 15 | 10 | 15 | 15 | 8 | 9 | 10 | 30 | 100 | 20 |
| | Average | 10 | 9 | 10 | 12 | 7 | 8 | 9 | 10 | 30 | 10 |
| Determination | | ○ | ○ | ○ | Δ | ○ | ○ | ○ | × | × | × |

Table 1 shows the results of measurements. As shown in Table 1, the adhesion strength was 4N/cm or more in each of examples 1 to 7, indicating that the tab wires 3 were firmly adhered to the Ag electrode 30. In contrast, in comparative examples 1 and 3, the adhesion strength was 1.5 N/cm, indicating that the adhesion strength was insufficient. This is because in examples 1 to 7, by forming the bending section 18 at the end of each of the tab wires 3, the binder resin 22 was prevented from flowing out with an unnecessarily high amount between the tab wire 3 and the Ag electrode 30, while in comparative example 1, since no bending section was installed, the binder resin excessively flowed out.

Moreover, the particle capturing rate was 60% or more in each of examples 1 to 7, indicating that electrical connection reliability was improved. In contrast, in each of comparative examples 1 to 3, the particle capturing rate was kept at about 40%. This is because in examples 1 to 7, nickel particles dispersed in the binder resin 22 were captured by the bending section 18 of the tab wire 3, while in comparative examples 1 and 3, no capturing effect of particles by the bending section 18 was obtained. Moreover, this is because in comparative example 2, since the bending distance (L) of the bending section was larger than the average particle size (R) of each nickel particle, with the result that the outflow of the binder resin 22 of the conductive adhesion film 17 was blocked and the nickel particles were not sandwiched by a gap to the Ag electrode 30 at the end of the tab wire.

Moreover, the initial conduction resistivity of each of examples 1 to 7 was 6Ω or less on average and 9Ω in the maximum value, and the conduction resistivity after the thermal impact test was also 12Ω or less on average and 15Ω in the maximum value so that a low resistivity was maintained. In contrast, in comparative example 1, the initial conduction resistivity was 8Ω on average and 15Ω in the maximum value, which were high levels, in comparative example 2, the conduction resistivity after the thermal impact test was 30Ω on average and 100Ω in the maximum value, which were higher levels, and in comparative example 3, the initial conduction resistivity was 7Ω on average and 10Ω in the maximum value, which were high levels, with the conduction resistivity after the thermal impact test being also raised to the maximum value of 20Ω. As described above, it is found that those configurations in accordance with examples 1 to 7 are sufficiently applicable to practical use in any of aspects of the adhesion strength, the particle capturing rate and the reliability of conduction resistivity.

Moreover, it is found that when examples 3, 5 and 6 are compared with one another, as the bending length L of the tab wire 3 increases, the adhesion strength also increases. When the length L increases, the volume of the conductive adhesion film 17 that can be sandwiched by the tab wire 3 and the solar cell 2 increases. That is, it is considered that since the thickness of the conductive adhesion film 17 after fusing/curing processes increases so that the adhesion strength increases. Moreover, since the bending section 18 is prepared at the end of the tab wire 3, the amount of the conductive adhesion film 17 that protrudes from the tab wire 3 at the end of the tab wire 3 increases so that the adhesion strength is further improved.

Moreover, in examples 1 to 3 as well as examples 5 to 7, since R - L ≤ 0 to 20µm is satisfied, the particle capturing rate of the conductive particles is further improved so that not only the initial conductivity value, but also the resistance value after the thermal impact test can be stabilized, thereby making it possible to maintain the reliability.

Furthermore, in examples 1 to 7, since the bending distance (L) of the bending section is set to 10 to 30µm, the range of selection of the conductive particles 23 that satisfy R - L ≤ 30µm can be widened.

### Reference Signs List

1...solar cell module, 2...solar cell, 3...tab wire, 3a...one main surface, 4...string, 5...matrix, 6...sheet, 7...surface cover, 8...back sheet, 9...metal frame, 10... photoelectric conversion element, 11...busbar electrode, 12...finger electrode, 13...rear surface electrode, 14...tab wire connection unit, 17...conductive adhesion film, 18...bending section, 23...conductive particles, 24...peeling base member, 25...reel, 30...Ag electrode, 31...glass substrate

## Claims

1. A solar cell module comprising:
a plurality of solar cells and a tab wire that connects the plurality of solar cells to one another by being adhered, via a conductive adhesive containing spherical conductive particles, to electrodes formed respectively on the front surface of a solar cell and on the rear surface of a neighboring solar cell so as to connect the plurality of solar cells to one after another,
wherein the tab wire has a bending section formed thereon in which an end portion in the longitudinal direction is bent onto the electrode side.

2. The solar cell module according to claim 1, wherein the bending section is configured such that a bending distance (L) from one main surface of the tab wire to a tip end thereof and an average particle diameter (R) of the conductive particles satisfy L ≤ R (L ≠ 0) as well as R - L ≤ 30µm.

3. The solar cell module according to claim 2, wherein the bending section is configured such that a bending distance (L) from one main surface of the tab wire to a tip end thereof and an average particle diameter (R) of the conductive particles satisfy R - L ≤ 0 to 20µm.

4. The solar cell module according to any one of claims 1 to 3, wherein the bending section is configured such that a bending distance (L) from one main surface of the tab wire to a tip end thereof is 10 to 30µm.

5. The solar cell module according to any one of claims 1 to 4, wherein the conductive particles are nickel particles.

6. A method of producing a solar cell module comprising the steps of:
disposing one end of a tab wire on a front surface electrode of a solar cell via a conductive adhesive containing spherical conductive particles, as well as disposing the other end of the tab wire on a rear surface electrode of a solar cell adjacent to the solar cell via a conductive adhesive containing spherical conductive particles; and
heating and pressing the tab wire onto the front surface electrode and the rear surface electrode so that the tab wire is adhered onto the front surface electrode and the rear surface electrode via the conductive adhesive,
wherein the tab wire has a bending section formed thereon in which an end portion in the longitudinal direction is bent onto the electrode side.

7. The method of producing a solar cell module according to claim 6, wherein in the adhering step, on the front surface and the rear surface of the solar cell, the conductive adhesive, the tab wire and a sealing material for sealing the solar cell are successively stacked and by carrying out a packaged laminating process, the tab wire is heated and pressed onto the front surface electrode and the rear surface electrode.

8. The method of producing a solar cell module according to claim 6 or 7, wherein the bending section is configured such that a bending distance (L) from one main surface of the tab wire to a tip end thereof and an average particle diameter (R) of the conductive particles satisfy L ≤ R (L ≠ 0) as well as R - L ≤ 30µm.

9. The method of producing a solar cell module according to claim 8, wherein the bending section is configured such that a bending distance (L) from one main surface of the tab wire to a tip end thereof and an average particle diameter (R) of the conductive particles satisfy R - L ≤ 0 to 20µm.

10. The method of producing a solar cell module according to any one of claims 6 to 9, wherein the bending section is configured such that a bending distance (L) from one main surface of the tab wire to a tip end thereof is 10 to 30µm.

11. The method of producing a solar cell module according to any one of claims 6 to 10, wherein the conductive particles are nickel particles.
